# EUROPÄISCHE PATENTSCHRIFT

(11) **EP 2 438 613 B1**
(45) Veröffentlichungstag und Bekanntmachung des Hinweises auf die Patenterteilung: **03.07.2019**
(21) Anmeldenummer: 10716549.0
(22) Anmeldetag: 05.05.2010
(51) Int. Cl.: H01L 25/16, H01L 33/64, H01L 33/48, H01L 33/62

(54) **OPTOELEKTRONISCHES HALBLEITERBAUELEMENT**
OPTOELECTRONIC SEMICONDUCTOR COMPONENT
COMPOSANT OPTOELECTRONIQUE A SEMI-CONDUCTEUR

(30) Priorität: 04.06.2009 DE 102009023854
(43) Veröffentlichungstag der Anmeldung: 11.04.2012
(73) Patentinhaber: OSRAM Opto Semiconductors GmbH, 93055 Regensburg (DE)
(72) Erfinder: PREUSS, Stephan, 93077 Bad Abbach (DE); ZITZLSPERGER, Michael, 93047 Regensburg (DE)
(74) Vertreter: Epping - Hermann - Fischer
(86) Internationale Anmeldenummer: PCT/EP2010/056118
(87) Internationale Veröffentlichungsnummer: WO 2010/139518

(56) Entgegenhaltungen:
- EP-A2- 0 921 568
- EP-A2- 1 998 380
- JP-A- 5 037 021
- JP-A- 5 327 027
- JP-A- 5 347 434
- JP-A- 2001 036 140
- JP-A- 2007 150 229
- US-A1- 2007 018 191
- US-A1- 2008 099 779

## Beschreibung

Es wird ein optoelektronisches Halbleiterbauelement angegeben.

Eine zu lösende Aufgabe besteht darin, ein besonders kompaktes Halbleiterbauelement anzugeben.

Die Druckschrift US 2007/018191 A1 beschreibt ein lichtemittierendes Halbleiterbauelement, bei dem ein Gehäuse aus mehreren Schichten elektrisch isolierender Substrate mit dazwischenliegenden Metallschichten und Durchkontaktierungen gebildet ist. In einer Kavität auf einer Seite des Gehäuses ist ein LED-Chip angeordnet und in einer Kavität mit geringerer lateraler Ausdehnung auf der gegenüberliegenden Seite des Gehäuses ist eine mit dem LED-Chip elektrisch verbundene Schutzdiode angeordnet.

Die Druckschrift US 2008/099779 A1 beschreibt als Stand der Technik die Anordnung eines LED-Chips auf einer Seite eines Leiterrahmens und eines mit dem LED-Chip elektrisch leitend verbundenen Anti-ESD-Schutzelementes auf der gegenüberliegenden Seite des Leiterrahmens, wobei der Leiterrahmen unterschiedlich dicke Bereiche aufweist und sowohl der LED-Chip als auch das Anti-ESD-Schutzelement auf einem relativ dünnen Bereich des Leiterrahmens angeordnet sind.

Gemäß der vorliegenden Erfindung umfasst das optoelektronische Halbleiterbauelement einen ersten Träger. Der Träger weist eine Oberseite sowie eine der Oberseite gegenüberliegende Unterseite auf. Bei dem ersten Träger handelt es sich um eine Trägerplatte aus elektrisch leitendem Material, nämlich aus einem Metall, die als elektrische Kontaktfläche für das Halbleiterbauelement dient.

In anderen, nicht erfindungsgemäßen Beispielen kann der erste Träger auch mit einem Grundkörper aus elektrisch isolierendem Material, beispielsweise einer Keramik, gebildet sein. Der Grundkörper kann dann an der Oberseite und/oder der Unterseite mit Anschlussstellen und Leiterbahnen versehen sein.

Der erste Träger weist einen ersten und einen zweiten Bereich auf. Das heißt, dass der erste Träger in Bereiche unterteilt ist, wobei sich die Bereiche hinsichtlich zumindest einer physikalischen Eigenschaft, nämlich ihrer Dicke in vertikaler Richtung, unterscheiden. "Dicke" bedeutet hierbei die Ausdehnung eines jeden der beiden Bereiche, wobei "vertikal" eine Richtung senkrecht zu einer Haupterstreckungsebene des ersten Trägers bedeutet. "Bereich" ist also in diesem Zusammenhang jede dreidimensionale Struktur, die den Träger zumindest stellenweise ausformt und bildet. Insofern bildet der erste zusammen mit dem zweiten Bereich den ersten Träger aus. Erster und zweiter Bereich gehen vorzugsweise direkt ineinander über, sodass sich zwischen dem ersten und dem zweiten Bereich weder ein Spalt noch eine Unterbrechung ausbildet. Der erste Träger ist einstückig ausgebildet und der erste und der zweite Bereich sind mit dem gleichen Material gebildet.

Gemäß der vorliegenden Erfindung weist der erste Bereich eine größere Dicke in vertikaler Richtung als der zweite Bereich auf.

Gemäß der vorliegenden Erfindung ist an der Oberseite auf dem ersten Träger zumindest ein optoelektronischer Halbleiterchip angeordnet. Bei dem optoelektronischen Halbleiterchip kann es sich beispielsweise um einen Lumineszenzdiodenchip handeln. Bei dem Lumineszenzdiodenchip kann es sich um einen Leucht- oder Laserdiodenchip handeln, der Strahlung im Bereich von ultraviolettem bis infrarotem Licht emittiert. Vorzugsweise emittiert der

Lumineszenzdiodenchip Licht im sichtbaren Bereich oder ultraviolettem Bereich des Spektrums der elektromagnetischen Strahlung. Ebenso kann es sich bei dem optoelektronischen Halbleiterchip auch um einen strahlungsempfangenden Chip, beispielsweise eine Fotodiode, handeln.

Der zumindest eine optoelektronische Halbleiterchip ist im ersten Bereich an der Oberseite angeordnet.

Gemäß der vorliegenden Erfindung weist das optoelektronische Halbleiterbauelement zumindest ein, zum Beispiel genau ein, elektronisches Bauteil auf, welches im zweiten Bereich an der Unterseite des ersten Trägers angeordnet ist.

Der erste Bereich überragt den zweiten Bereich an der Unterseite in vertikaler Richtung. Das kann heißen, dass die Oberseite des ersten Trägers eine Ebene ohne Erhebungen oder Senkungen und damit "eben" ist, während die Unterseite aufgrund des Überragens des zweiten Bereichs durch den ersten Bereich eine Erhebung, beispielsweise in Form einer Stufe, aufweist. Mit anderen Worten ist der Träger in einer lateralen Richtung in zumindest zwei Bereiche unterteilt, wobei der Träger im ersten Bereich in vertikaler Richtung eine größere Dicke als im zweiten Bereich aufweist.

Weiter ist das zumindest eine elektronische Bauteil elektrisch leitend mit dem zumindest einen optoelektronischen Halbleiterchip verbunden. Beispielsweise kann dies dadurch realisiert werden, dass der erste Träger selbst elektrisch leitend ist oder mittels elektrischer Leiterbahnen und Kontaktanschlüsse eine elektrische Kontaktierung zwischen dem elektronischen Bauteil und dem optoelektronischen Halbleiterchip hergestellt wird.

Gemäß der vorliegenden Erfindung des optoelektronischen Halbleiterbauelements umfasst das Halbleiterbauelement einen ersten Träger, der eine Oberseite sowie eine der Oberseite des ersten Trägers gegenüberliegende Unterseite aufweist, wobei der erste Träger einen ersten und einen zweiten Bereich aufweist. Ferner weist das optoelektronische Halbleiterbauelement zumindest einen optoelektronischen Halbleiterchip auf, der an der Oberseite auf dem ersten Träger angeordnet ist. Weiter weist das optoelektronische Halbleiterbauelement zumindest ein elektronisches Bauteil auf, welches im zweiten Bereich an der Unterseite des ersten Trägers angeordnet ist. Der erste Bereich weist eine größere Dicke in vertikaler Richtung als der zweite Bereich auf, wobei an der Unterseite der erste Bereich den zweiten Bereich in vertikaler Richtung überragt und das zumindest eine elektronische Bauteil elektrisch leitend mit dem zumindest einen optoelektronischen Halbleiterchip verbunden ist.

Das hier beschriebene optoelektronische Halbleiterbauelement beruht dabei unter anderem auf der Erkenntnis, dass eine Anbringung eines elektronischen Bauteils auf derselben Fläche, beispielsweise einer Oberseite eines Trägers, neben beispielsweise einem Halbleiterchip platzaufwändig ist, da dann die Oberseite groß genug gewählt werden muss, sodass beide Bauteile, der optoelektronische Halbleiterchip und das elektronische Bauteil, gemeinsam auf der Oberseite angebracht werden können. Insbesondere führt dies zu Einschränkungen in der Beschaffenheit und der Geometrie des Trägers, da beispielsweise ein Kompromiss zwischen der Größe des Halbleiterbauelements und den Abstrahlungseigenschaften des Halbleiterbauelements gefunden werden muss.

Um nun ein Halbleiterbauelement zu schaffen, welches ganz besonders kompakt und Platz sparend ist, macht das hier beschriebene optoelektronische Halbleiterbauelement von der Idee Gebrauch, einen Träger zu verwenden, der einen ersten und einen zweiten Bereich aufweist, wobei der erste Bereich eine größere Dicke in vertikaler Richtung als der zweite Bereich aufweist und an der Unterseite den zweiten Bereich in vertikaler Richtung überragt. Ein elektronisches Bauteil ist dann an der Unterseite im zweiten Bereich des ersten Trägers angeordnet, wobei gleichzeitig ein optoelektronischer Halbleiterchip an der Oberseite des Trägers angeordnet ist. Optoelektronischer Halbleiterchip und elektronisches Bauteil befinden sich somit an gegenüberliegenden Seiten des Trägers. Durch die Platzierung des elektronischen Bauteils auf einer der Oberseite, und somit auch dem Halbleiterchip, gegenüberliegenden Seite wird so vorteilhaft ermöglicht, zumindest die laterale Ausdehnung des Trägers beziehungsweise des optoelektronischen Halbleiterbauelements zu verringern. Ferner kann die zur Anbringung des elektronischen Bauteils gestaltete Unterseite, an der das zumindest eine elektronische Bauteil angebracht ist, als elektrische Kontaktmarkierung für das Halbleiterbauelement dienen. Das heißt, dass zum Beispiel der zweite Bereich oder das elektronische Bauteil selbst als Kathodenmarkierung dienen können.

Gemäß der vorliegenden Erfindung überragt das zumindest eine elektronische Bauteil den ersten Träger in vertikaler Richtung nicht. Das kann heißen, dass der erste Bereich das elektronische Bauteil überragt oder das zumindest eine elektronische Bauteil in lateraler Richtung mit dem ersten Bereich bündig abschließt. Vorteilhaft wird dadurch, dass das zumindest eine elektronische Bauteil den ersten Träger in vertikaler Richtung nicht überragt, die vertikale Ausdehnung des Bauelements möglichst gering gehalten, da in diesem Fall die Dicke des ersten Bereichs zusammen mit der vertikalen Ausdehnung des zumindest einen optoelektronischen Halbleiterchips gleichzeitig die maximale vertikale Ausdehnung des gesamten Halbleiterbauelements sein kann. Ferner kann dann die Unterseite im ersten Bereich eine Montage- beziehungsweise Kontaktfläche für das Halbleiterbauelement bilden.

Gemäß zumindest einer Ausführungsform des optoelektronischen Halbleiterbauelements ist der zweite Bereich durch eine Hinterschneidung im ersten Träger gebildet.

"Hinterschneidung" bedeutet in diesem Zusammenhang eine randseitige Aussparung im ersten Träger, welche von außen frei zugänglich ist und durch zumindest zwei Seitenflächen des ersten Trägers begrenzt ist. Beispielsweise ist die Hinterschneidung mittels Ätzen, Prägen, Stanzen, Sägen, Fräsen oder einer anderen Form des Materialabtrags in den ersten Träger eingebracht. Beispielsweise wird durch die Hinterschneidung die Dicke in vertikaler Richtung ausgehend vom zweiten Bereich in Richtung des ersten Bereichs "plötzlich", beispielsweise in Form einer Stufe, vergrößert. "Plötzlich" heißt in diesem Zusammenhang, dass die Unterseite in lateraler Richtung, also parallel zur

Haupterstreckungsebene des ersten Trägers, von einer Stelle auf die nächste vorgebbar eine Veränderung in der vertikalen Ausdehnung aufweist. Ebenso ist es möglich, dass der zweite Bereich durch eine Vielzahl von Hinterschneidungen gebildet ist, die dann eine stufenförmige Treppenstruktur ausbilden. Denkbar ist dann, dass auf einer oder mehreren Stufen jeweils ein elektronisches Bauteil angebracht ist.

Gemäß zumindest einer Ausführungsform des optoelektronischen Halbleiterbauelements ist der zweite Bereich durch eine Ausnehmung im ersten Träger gebildet. Die Ausnehmung ist eine Vertiefung im Träger, die eine Öffnung aufweist und von der Unterseite frei zugänglich ist. Ferner weist die Ausnehmung zum Beispiel eine Bodenfläche und zumindest eine Seitenfläche auf. Boden- und Seitenfläche sind durch den Träger gebildet. Die Bodenfläche kann sich auf der der Öffnung gegenüberliegenden Seite der Ausnehmung befinden. Die Öffnung und die Bodenfläche sind durch die Seitenfläche miteinander verbunden. Auch in diesem Fall ist es möglich, dass statt nur einer Ausnehmung mehrere Ausnehmungen unterschiedlicher Ausdehnung in den ersten Träger eingebracht sind, die dann jeweils treppenförmige Vorsprünge ausbilden, an denen beispielsweise jeweils ein elektronisches Bauteil angebracht ist.

Gemäß zumindest einer Ausführungsform umrandet der zweite Bereich den ersten Bereich an zumindest drei Seiten. Ebenso ist es möglich, dass der zweite Bereich den ersten Bereich vollständig, beispielsweise rahmenförmig, umschließt. Zum Beispiel verläuft eine den zweiten Bereich ausbildende Hinterschneidung entlang des Randes des ersten Trägers an drei Seiten.

Gemäß zumindest einer Ausführungsform des optoelektronischen Halbleiterbauelements sind der optoelektronische Halbleiterchip und das elektronische Bauteil jeweils mittels eines Bonddrahtes mit einem weiteren Träger elektrisch leitend verbunden. Der weitere Träger kann aus gleichen oder unterschiedlichen Materialien wie der erste Träger gebildet sein. Ferner kann der weitere Träger die gleichen geometrischen Merkmale beispielsweise in Bezug auf die Unterteilung in einen ersten und einen zweiten Bereich aufweisen. Zum Beispiel ist der weitere Träger, ebenso wie der erste Träger, durch einen ersten und einen zweiten Bereich gebildet, wobei auch in diesem Fall der erste Bereich den zweiten Bereich in vertikaler Richtung an der Unterseite überragt. Das oder ein weiteres elektronisches Bauteil kann dann im zweiten Bereich an der Unterseite des weiteren Trägers angeordnet sein.

Gemäß zumindest einer Ausführungsform ist der zumindest eine optoelektronische Halbleiterchip von einem Gehäusekörper seitlich umrandet. Der Gehäusekörper bedeckt dann zumindest stellenweise die Oberseite des ersten und/oder des weiteren Trägers. Beispielsweise umrandet in lateraler Richtung der Gehäusekörper den optoelektronischen Halbleiterchip kreisförmig, oval oder rechteckförmig. Beispielsweise bedeckt der Gehäusekörper bis auf einen Chipmontagebereich die Oberfläche des ersten und/oder zweiten Trägers vollständig. Der Gehäusekörper kann mit einem duro- oder thermoplastischen Material, beispielsweise einem Epoxid, gebildet sein oder auch mit einem keramischen Material gebildet sein oder aus einem solchen bestehen. Ebenso ist es möglich, dass der Gehäusekörper mit einem Silikon oder anderen, beispielsweise gummiartigen, Materialien oder Mischungen der genannten Materialien gebildet ist.

Gemäß zumindest einer Ausführungsform umformt der Gehäusekörper das zumindest eine elektronische Bauteil zumindest stellenweise. "Umformt" heißt in diesem Zusammenhang, dass der Gehäusekörper mit dem elektronischen Bauteil in direktem Kontakt steht, das elektronische Bauteil zumindest stellenweise einschließt und sich so zwischen dem Gehäusekörper und dem elektronischen Bauteil weder ein Spalt noch eine Unterbrechung ausbildet. Vorteilhaft ist so das elektronische Bauteil durch den Gehäusekörper vor äußeren Einflüssen wie beispielsweise Feuchtigkeit oder mechanischen Belastungen geschützt. Das heißt, dass der erste Träger dann an der Unterseite nur im ersten Bereich frei vom Gehäusekörper ist und im zweiten Bereich vom Gehäusekörper bedeckt ist.

Vorteilhaft muss durch die Platzierung des elektronischen Bauteils auf der Unterseite des ersten Trägers die vertikale Ausdehnung des Gehäusekörpers über der Oberseite des ersten Trägers neben der vertikalen Ausdehnung des optoelektronischen Halbleiterchips nicht mehr zusätzlich die vertikale Ausdehnung des elektronischen Bauteils und einer eventuellen Bondkontaktierung mit einschließen. Dies führt zu einem ganz besonders flachen Gehäuse, da für die vertikale Ausdehnung des Gehäusekörpers nur noch die vertikale Ausdehnung des zumindest einen optoelektronischen Halbleiterchips maßgebend ist.

Ebenso kann ein Gehäusekörper realisiert werden, der durch die Verkleinerung der Oberseite des ersten Trägers eine geringe laterale Ausdehnung aufweist.

Gemäß zumindest einer Ausführungsform des optoelektronischen Halbleiterbauelements überragt der Gehäusekörper den ersten Bereich an der Unterseite in vertikaler Richtung nicht. Überragt das elektronische Bauteil den ersten Bereich nicht, so ist denkbar, dass auch der Gehäusekörper den ersten Bereich nicht überragt. Ebenso ist es möglich, dass der Gehäusekörper in lateraler Richtung bündig mit der Unterseite im ersten Bereich abschließt.

Vorteilhaft ermöglicht dies, dass die an der Unterseite des ersten Trägers freiliegenden Stellen des ersten Bereichs als Kontakt- beziehungsweise Montagefläche für das Halbleiterbauelement dienen können, während der zweite Bereich mit dem elektronischen Bauteil vollständig vom Gehäusekörper bedeckt ist.

Gemäß zumindest einer Ausführungsform des optoelektronischen Halbleiterbauelements verbindet der Gehäusekörper den ersten Träger mit dem weiteren Träger mechanisch. Das kann heißen, dass neben dem ersten Träger auch der weitere Träger an seiner Ober- beziehungsweise Unterseite sowie den Seitenflächen mit dem Gehäusekörper zumindest stellenweise bedeckt ist und der Gehäusekörper so ein mechanisches Verrutschen der beiden Träger gegeneinander verhindert. Vorteilhaft wird so ein Bauelement geschaffen, welches ganz besonders stabil gegen beispielsweise äußere mechanische Einwirkung ist und so der erste Träger und der weitere Träger in ihrer Position zueinander stabilisiert werden. Ferner kann der Gehäusekörper elektrisch isolierend zwischen den beiden Trägern sein.

Gemäß einer ersten Ausführungsform enthält oder ist das elektronische Bauelement eine Schutzschaltung gegen Schäden durch elektrostatische Aufladung. Beispielweise kann es sich bei dem elektronischen Bauelement um ein ESD (electro static discharge) -Schutzelement handeln. Das ESD-Schutzelement ist geeignet, Spannungsspitzen, die beispielsweise in Sperrrichtung des optoelektronischen Halbleiterchips auftreten, abzuleiten. Bei dem ESD-Schutzelement handelt es sich beispielsweise um eines der folgenden Komponenten: Varistor, Leuchtdiodenchip, Zenerdiode, Widerstand. Das ESD-Schutzelement ist dann parallel beziehungsweise antiparallel zum optoelektronischen Halbleiterchip verschaltet.

Handelt es sich bei dem elektronischen Bauelement etwa um einen Leuchtdiodenchip, so ist dieser antiparallel zum optoelektronischen Halbleiterchip verschaltet. Dieser Leuchtdiodenchip kann dann ebenfalls zur Strahlungserzeugung genutzt werden.

Gemäß einer zweiten Ausführungsform des optoelektronischen Halbleiterbauelements enthält das zumindest eine elektronische Bauelement eine Ansteuerschaltung für den zumindest einen optoelektronischen Halbleiterchip. Mittels der Ansteuerschaltung kann der optoelektronische Halbleiterchip beispielsweise im Hinblick auf Helligkeit und Wärmeentwicklung gesteuert werden.

Im Folgenden wird das hier beschriebene Bauelement anhand von Ausführungsbeispielen und der zugehörigen Figuren näher erläutert.

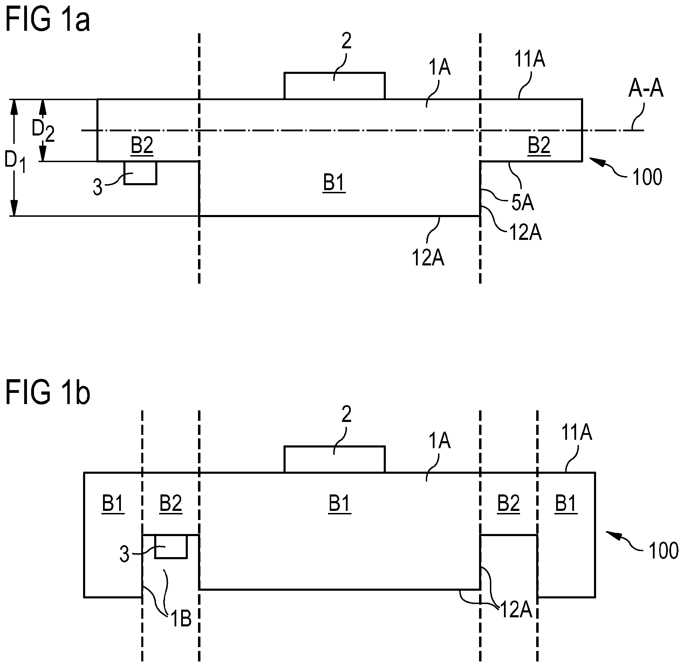

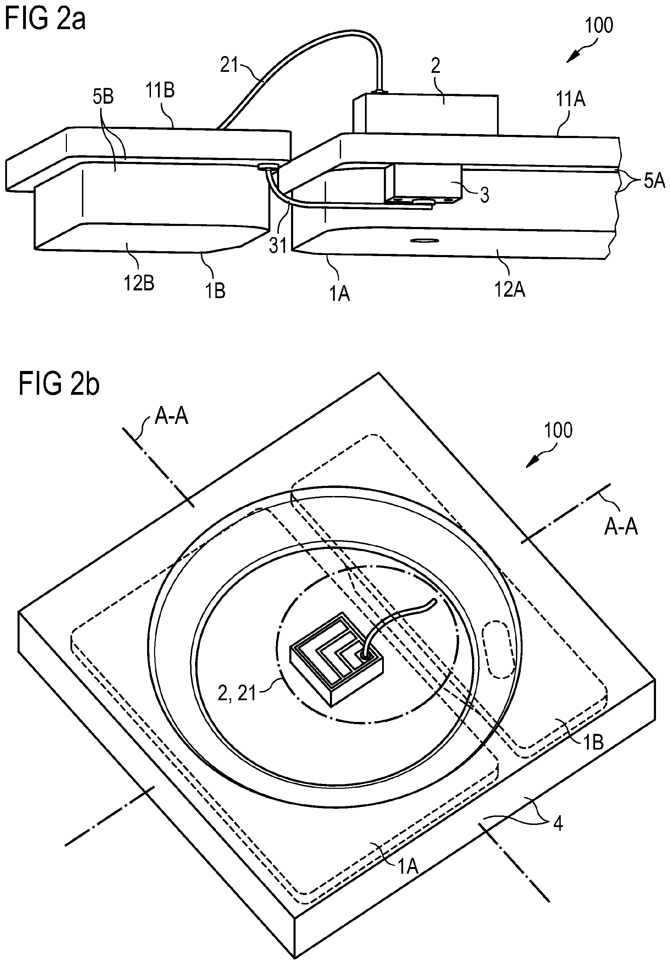

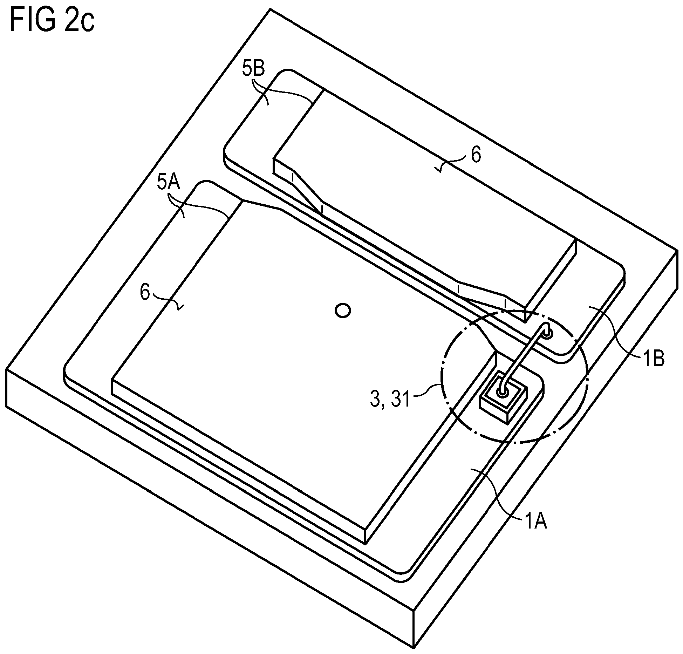

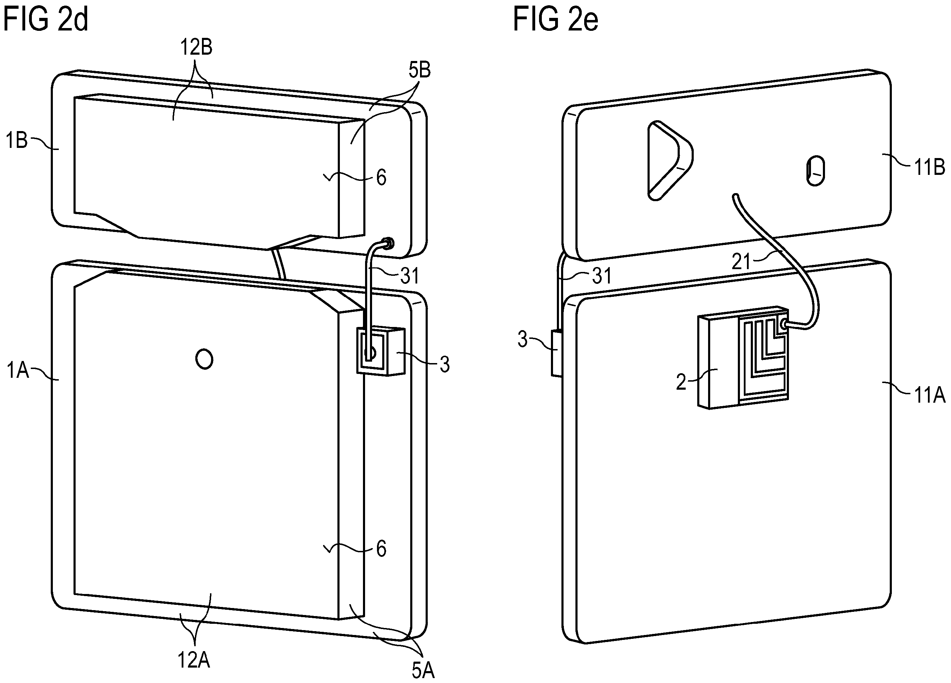

Die Figuren 1a, 1b, 2a, 2b, 2c, 2d und 2e zeigen schematische Ansichten von Ausführungsbeispielen eines hier beschriebenen optoelektronischen Halbleiterbauelements.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

Die Figur 1a zeigt in einer schematischen Schnittdarstellung entlang einer Schnittlinie A-A ein Ausführungsbeispiel eines hier beschriebenen optoelektronischen Halbleiterbauelements 100. Der erste Träger 1A weist eine Oberseite 11A sowie eine der Oberseite 11A gegenüberliegende Unterseite 12A auf.

Ferner weist der erste Träger 1A einen ersten Bereich B1 und einen zweiten Bereich B2 auf. Der zweite Bereich B2 ist durch eine Hinterschneidung 5A gebildet, wobei der erste Bereich B1 eine Dicke D1 und der zweite Bereich B2 eine Dicke D2 aufweist. Die Hinterschneidung 5A ist durch zwei Seitenflächen des Trägers 1A begrenzt, wobei auf einer der Seitenflächen ein elektronisches Bauteil 3 angebracht ist. Im ersten Bereich B1 ist an einer Oberseite 11A des Trägers 1A ist ein optoelektronischer Halbleiterchip 2 angebracht. Der optoelektronische Halbleiterchip 2 und das elektronische Bauteil 3 befinden sich also an gegenüberliegenden Seiten des Trägers 1A. Vorliegend ist die Dicke D1 des ersten Bereichs B1 größer als die aufaddierte Dicke D2 des zweiten Bereichs B2 und der vertikalen Ausdehnung des elektronischen Bauteils 3.

In Figur 1b ist an einer schematischen Schnittdarstellung ein weiteres Ausführungsbeispiel gemäß eines hier beschriebenen optoelektronischen Halbleiterbauelements 100 beschrieben, bei dem der zweite Bereich B2 durch eine Ausnehmung 13 gebildet ist. Vorliegend ist die Ausnehmung 13 jeweils durch drei Seitenflächen des Trägers 1A seitlich begrenzt. An einer Bodenfläche der Ausnehmung 13 ist das elektronische Bauteil 3 angebracht. Vorteilhaft gewährt insbesondere die Ausnehmung 13 dem elektronischen Bauteil Schutz vor äußeren Einwirkungen wie zum Beispiel mechanischer Belastung.

Sowohl in Figur 1a als auch in Figur 1b umrandet der zweite Bereich B2 den ersten Bereich B1 an drei Seiten.

In der Figur 2a ist anhand einer schematisch perspektivischen Seitenansicht das Ausführungsbeispiel gemäß der Figur 1a mit dem ersten Träger 1A, dem optoelektronischen Halbleiterchip 2, der auf der Oberseite 11A des Trägers 1A angebracht ist, näher erläutert. Im vorliegenden Beispiel handelt es sich bei dem Träger 1A um einen metallischen Trägerstreifen, zum Beispiel aus Kupfer, durch den der Halbleiterchip 2 elektrisch kontaktiert ist. Ferner ist der optoelektronische Halbleiterchip 2 durch eine Bonddrahtkontaktierung 21 mit einem weiteren Träger 1B elektrisch leitend kontaktiert. Bei dem weiteren Träger 1B kann es sich ebenso um einen metallischen Trägerstreifen, zum Beispiel aus Kupfer, handeln. Ferner ist denkbar, dass der erste Träger 1A und/oder der weitere Träger 1B aus einem keramischen Material gebildet sind, wobei dann der optoelektronische Halbleiterchip 2 mittels auf den Trägern 1A und 1B aufgebrachter Leiterbahnen und Kontaktstellen elektrisch kontaktiert ist. Die Träger 1A und 1B sind ferner voneinander elektrisch isoliert. Ferner weist auch der Träger 1B eine Unterseite 12B sowie eine über die in den zweiten Träger 1B eingebrachte eine Hinterschneidung 5B auf. Beispielsweise ist die Hinterschneidung 5B mittels eines Ätzprozesses in den Träger 1B eingebracht. Mittels einer Bonddrahtkontaktierung 31 ist das elektronische Bauteil 3 mit dem weiteren Träger 1B elektrisch leitend kontaktiert, wobei die Hinterschneidung 5B als Kontaktbereich für die Bonddrahtkontaktierung 31 dient. Vorliegend handelt es sich bei dem elektronischen Bauteil 3 um ein Bauteil, welches eine ESD-Schutzschaltung aufweist.

Die Figur 2b zeigt das Ausführungsbeispiel gemäß der Figur 1a und 2a in einer schematisch perspektivischen Draufsicht. Im Vergleich zu dem in Figur 1a gezeigten Halbleiterbauelement 100 ist nun das Halbleiterbauelement 100 mit einem Gehäusekörper 4 versehen. Der Gehäusekörper umrandet den Halbleiterchip 2 kreisförmig und bedeckt alle freiliegenden Stellen der Oberseiten 11A und 11B der Träger 1A und 1B. Der Gehäusekörper 4 verbindet die beiden Träger 1A und 1B mechanisch miteinander. Ferner sorgt der Gehäusekörper 4 für eine elektrische Isolierung der beiden Träger 1A und 1B. Vorliegend ist der Gehäusekörper 4 mit einem duro- oder thermoplastischen Material, beispielsweise einem Epoxid, gebildet. Ebenso ist es möglich, dass der Gehäusekörper 4 mit einem keramischen Material gebildet sein oder aus einem solchen bestehen kann.

Figur 2c zeigt in einer schematisch perspektivischen Unteransicht das Ausführungsbeispielgemäß der Figur 2b. Erkennbar ist wiederum das an der Hinterschneidung 5A angebrachte elektronische Bauteil 3, welches mittels der Bonddrahtkontaktierung 31 mit dem weiteren Träger 1B im Bereich der Hinterschneidung 5B elektrisch kontaktiert ist. Ferner ist erkennbar, dass der Gehäusekörper 4 das elektronische Bauteil 3 vollständig umformt und mit einer Kontaktfläche 6 in lateraler Richtung bündig abschließt.

Die Figuren 2d und 2e zeigen weitere schematische Seitenbeziehungsweise Unteransichten des Ausführungsbeispiels gemäß der Figuren 1a und 2a, 2b und 2c.

## Patentansprüche

1. Optoelektronisches Halbleiterbauelement (100), mit
- einem ersten Träger (1A), der einstückig und aus einem Metall gebildet ist und der eine Oberseite (11A) sowie eine der Oberseite (11A) des ersten Trägers (1A) gegenüberliegende Unterseite (12A) aufweist, wobei der erste Träger (1A) einen ersten und einen zweiten Bereich (B1, B2) aufweist, in denen der erste Träger (1A) unterschiedlich dick ist;
- zumindest einem optoelektronischen Halbleiterchip (2), der im ersten Bereich (B1) an der Oberseite (11A) auf dem ersten Träger (1A) angeordnet ist;
- zumindest einem elektronischen Bauteil (3), welches im zweiten Bereich (B2) an der Unterseite (12A) des ersten Trägers (1A) angeordnet ist; wobei
- der erste Träger (1A) im ersten Bereich (B1) eine größere Dicke senkrecht zu einer Haupterstreckungsrichtung des ersten Trägers (1A) als im zweiten Bereich (B2) aufweist,
- an der Unterseite (12A) der erste Bereich (B1) den zweiten Bereich (B2) senkrecht zu der Haupterstreckungsrichtung des ersten Trägers (1A) überragt,
- das zumindest eine elektronische Bauteil (3) elektrisch leitend mit dem zumindest einen optoelektronischen Halbleiterchip (2) verbunden ist, wobei das elektronische Bauteil (3) den ersten Bereich (B1) des ersten Trägers (1A) in eine Richtung weg von der Unterseite (12A) nicht überragt,
- das zumindest eine elektronische Bauteil (3) eine Schutzschaltung gegen Schäden durch elektrostatische Aufladung und/oder eine Ansteuerschaltung für den zumindest einen optoelektronischen Halbleiterchip (2) enthält.

2. Optoelektronisches Halbleiterbauelement (100) nach Anspruch 1,
bei dem der zweite Bereich (B2) durch eine Hinterschneidung (5A) im ersten Träger (1A) gebildet ist.

3. Optoelektronisches Halbleiterbauelement (100) nach Anspruch 1,
bei dem der zweite Bereich (B2) durch eine Ausnehmung (13) im ersten Träger (1A) gebildet ist.

4. Optoelektronisches Halbleiterbauelement (100) nach einem der vorhergehenden Ansprüche,
bei dem der zweite Bereich (B2) den ersten Bereich (B1) an zumindest drei Seiten umrandet.

5. Optoelektronisches Halbleiterbauelement (100) nach einem der vorhergehenden Ansprüche, weiter umfassend einen weiteren Träger (1B), wobei der optoelektronische Halbleiterchip (2) und das elektronische Bauteil (3) jeweils mittels eines Bonddrahtes (21, 31) mit dem weiteren Träger (1B) elektrisch leitend verbunden ist.

6. Optoelektronisches Halbleiterbauelement (100) nach einem der vorhergehenden Ansprüche,
bei dem der zumindest eine optoelektronische Halbleiterchip (2) von einem Gehäusekörper (4) seitlich umrandet ist.

7. Optoelektronisches Halbleiterbauelement (100) nach dem vorhergehenden Anspruch,
bei dem der Gehäusekörper (4) das zumindest eine elektronische Bauteil (3) zumindest stellenweise umformt.

8. Optoelektronisches Halbleiterbauelement (100) nach Anspruch 6 oder 7,
bei dem der Gehäusekörper (4) an der Unterseite (12A) den ersten Bereich (B1) senkrecht zu der Haupterstreckungsrichtung des ersten Trägers (1A) nicht überragt.

9. Optoelektronisches Halbleiterbauelement (100) nach Anspruch 5 und nach einem der Ansprüche 6 bis 8,
bei dem der Gehäusekörper (4) den ersten Träger (1A) mit dem weiteren Träger (1B) mechanisch verbindet.

## Claims

1. Optoelectronic semiconductor device (100), with
- a first support (1A) which is integrally formed of a metal and which has an upper side (11A) and a lower side (12A) opposite the upper side (11A) of the first support (1A), the first support (1A) having a first and a second region (B1, B2) in which the first support (1A) is of different thickness;
- at least one optoelectronic semiconductor chip (2) disposed in said first region (B1) at the upper side (11A) of said first support (1A);
- at least one electronic component (3) which is arranged in the second region (B2) on the lower side (12A) of the first support (1A); wherein
- the first support (1A) has a greater thickness perpendicular to a main extension direction of the first support (1A) in the first region (B1) than in the second region (B2),
- on the lower side (12A), the first region (B1) projects beyond the second region (B2) perpendicular to the main extension direction of the first support (1A),
- the at least one electronic component (3) is electrically conductively connected to the at least one optoelectronic semiconductor chip (2), wherein the electronic component (3) does not project beyond the first region (B1) of the first support (1A) in a direction away from the lower side (12A),
- the at least one electronic component (3) contains a protective circuit against damage by electrostatic charging and/or a drive circuit for the at least one optoelectronic semiconductor chip (2).

2. Optoelectronic semiconductor device (100) according to claim 1,
in which the second region (B2) is formed by an undercut (5A) in the first support (1A).

3. Optoelectronic semiconductor device (100) according to claim 1,
in which the second region (B2) is formed by a recess (13) in the first support (1A).

4. Optoelectronic semiconductor device (100) according to one of the preceding claims,
in which the second region (B2) borders the first region (B1) on at least three sides.

5. Optoelectronic semiconductor device (100) according to one of the preceding claims, further comprising a further support (1B), the optoelectronic semiconductor chip (2) and the electronic component (3) each being electrically conductively connected to the further support (1B) by means of a bonding wire (21, 31).

6. Optoelectronic semiconductor device (100) according to one of the preceding claims,
in which the at least one optoelectronic semiconductor chip (2) is laterally surrounded by a housing body (4).

7. Optoelectronic semiconductor device (100) according to the preceding claim,
in which the housing body (4) at least partially reshapes the at least one electronic component (3).

8. Optoelectronic semiconductor device (100) according to claim 6 or 7,
in which the housing body (4) on the lower side (12A) does not project beyond the first region (B1) perpendicular to the main extension direction of the first support (1A).

9. Optoelectronic semiconductor device (100) according to claim 5 and one of claims 6 to 8,
in which the housing body (4) mechanically connects the first support (1A) to the further support (1B).

## Revendications

1. Composant semi-conducteur optoélectronique (100), comprenant
- un premier support (1A), qui est constitué d'un seul tenant et en métal et qui présente une face supérieure (11A) ainsi qu'une face inférieure (12A) située à l'opposé de la face supérieure (11A) du premier support (1A), le premier support (1A) présentant une première et une deuxième zone (B1, B2) dans lesquelles le premier support (1A) est d'épaisseur différente ;
- au moins une puce semi-conductrice optoélectronique (2) qui est agencée dans la première zone (B1) sur la face supérieure (11A) sur le premier support (1A) ;
- au moins une pièce électronique (3) qui est agencée dans la deuxième zone (B2) sur la face inférieure (12A) du premier support (1A) ;
- le premier support (1A) présentant dans la première zone (B1) une plus grande épaisseur à la perpendiculaire d'une direction principale d'allongement du premier support (1A) que dans la deuxième zone (B2),
- sur la face inférieure (12A), la première zone (B1) dépassant la deuxième zone (B2) à la perpendiculaire de la direction principale d'allongement du premier support (1A),
- ladite au moins une pièce électronique (3) étant connectée de manière électroconductrice à ladite au moins une puce semi-conductrice optoélectronique (2), la pièce électronique (3) ne dépassant pas la première zone (B1) du premier support (1A) dans une direction partant de la face inférieure (12A),
- ladite au moins une pièce électronique (3) contenant un circuit de protection contre les dommages provoqués par des charges électrostatiques et/ou un circuit de commande pour ladite au moins une puce semi-conductrice optoélectronique (2).

2. Composant semi-conducteur optoélectronique (100) selon la revendication 1,
dans lequel la deuxième zone (B2) est constituée par une échancrure (5A) dans le premier support (1A).

3. Composant semi-conducteur optoélectronique (100) selon la revendication 1,
dans lequel la deuxième zone (B2) est constituée par une entaille (13) dans le premier support (1A).

4. Composant semi-conducteur optoélectronique (100) selon l'une quelconque des revendications précédentes,
dans lequel la deuxième zone (B2) entoure la première zone (B1) sur au moins trois côtés.

5. Composant semi-conducteur optoélectronique (100) selon l'une quelconque des revendications précédentes, comprenant en outre un autre support (1B), la puce semi-conductrice optoélectronique (2) et la pièce électronique (3) étant chacune connectée de manière électroconductrice à l'autre support (1B) par un fil de connexion (21, 31).

6. Composant semi-conducteur optoélectronique (100) selon l'une quelconque des revendications précédentes,
dans lequel ladite au moins une puce semi-conductrice (2) est entourée sur les côtés par un corps de boîtier (4) .

7. Composant semi-conducteur optoélectronique (100) selon la revendication précédente,
dans lequel le corps de boîtier (4) donne au moins partiellement une forme à ladite au moins une pièce électronique (3).

8. Composant semi-conducteur optoélectronique (100) selon la revendication 6 ou 7,
dans lequel le corps de boîtier (4), sur la face inférieure (12A), ne dépasse pas la première zone (B1) à la perpendiculaire de la direction principale d'allongement du premier support (1A).

9. Composant semi-conducteur optoélectronique (100) selon la revendication 5 et selon l'une quelconque des revendications 6 à 8,
dans lequel le corps de boîtier (4) relie par liaison mécanique le premier support (1A) à l'autre support (1B) .
